# EUROPEAN PATENT SPECIFICATION

(11) **EP 1 218 927 B1**
(45) Date of publication and mention of the grant of the patent: **15.12.2004**
(21) Application number: 00966991.2
(22) Date of filing: 27.09.2000
(51) Int. Cl.: H01L 21/00, G02F 1/15

(54) **A METHOD AND SYSTEM FOR REDUCING PHOTO-ASSISTED CORROSION IN WAFERS DURING CLEANING PROCESSES**
VERFAHREN UND SYSTEM ZUR VERMINDERUNG VON PHOTOCHEMISCHER KORROSION BEI REINIGUNGSPROZESSEN
PROCEDE ET SYSTEME POUR LA REDUCTION DE LA CORROSION PHOTO-ASSISTEE DANS DES PLAQUETTES DURANT LES PROCESSUS DE NETTOYAGE

(30) Priority: 29.09.1999 US 408001
(43) Date of publication of application: 03.07.2002
(73) Proprietor: LAM RESEARCH CORPORATION, Fremont, CA 94538 (US)
(72) Inventor: TREICHEL, Helmuth, W., Milpitas, CA 95035 (US); SVIRCHEVSKI, Julia, S., San Jose, CA 95131 (US); RAVKIN, Mike, Sunnyvale, CA 94087 (US)
(74) Representative: Thomson, Paul Anthony
(86) International application number: PCT/US2000/026611
(87) International publication number: WO 2001/024232

(56) References cited:
- EP-A- 0 461 685
- US-A- 5 379 146
- US-A- 5 585 959
- US-A- 5 729 379

## Description

### 1. Field of the Invention

The present invention relates generally to semiconductor wafer cleaning and, more particularly, to techniques for reducing photo-corrosion on wafers used to fabricate semiconductor devices.

### 2. Description of the Related Art

In the semiconductor chip fabrication process, it is well-known that there is a need to clean the surface of the wafer after a chemical mechanical polishing (CMP) process. A copper (Cu) CMP process leaves many types of contaminants such as particles and metallic ions on the wafer surface. Cleaning is therefore necessary to avoid the degradation of the electrical characteristics of the dielectrics.

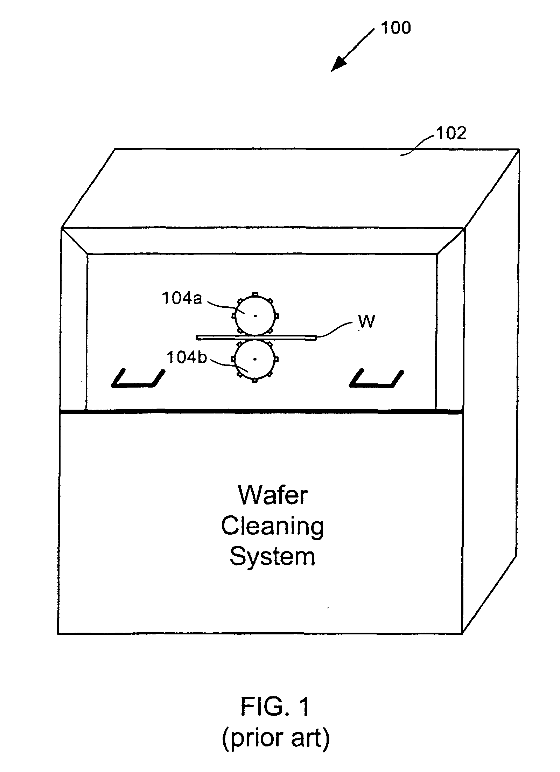

For purposes of discussion only, Figure 1 shows a simplified wafer cleaning system having a brush box 100. After a copper CMP process, the wafer is sometimes put through HF containing cleaning process in the wafer cleaning system. The wafer enters the brush box 100 where the wafer may be inserted between a top brush 104a and a bottom brush 104b. The wafer is typically rotated by the brushes 104 and a set of rollers (not shown), thereby enabling the brushes 104 to adequately clean the top and bottom surfaces of the wafer. The cleaning process can be viewed through the brush box cover 102, which is typically a clear plastic material.

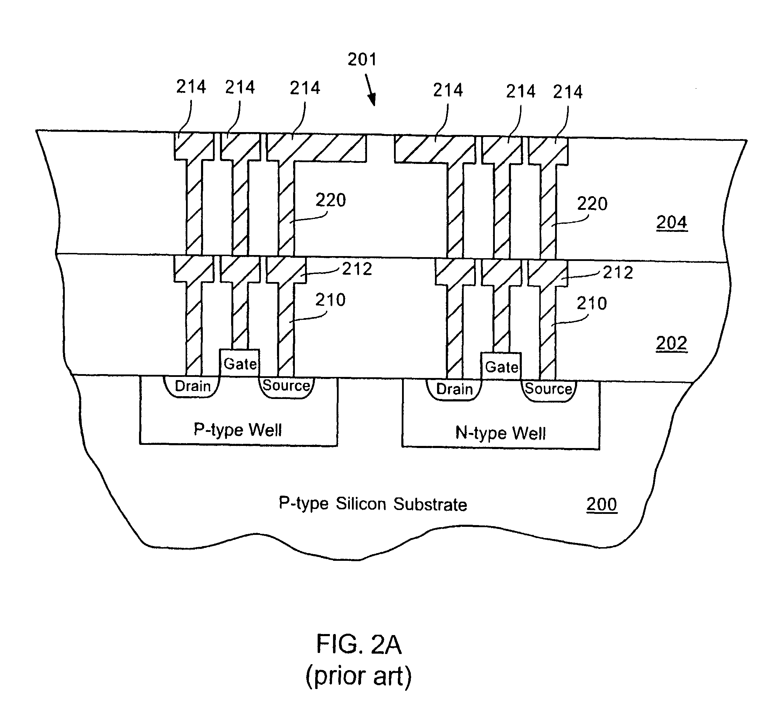

Figure 2A shows a partial cross-sectional view of an exemplary semiconductor chip 201 after the top layer has undergone a copper CMP process. Using standard impurity implantation, photolithography, and etching techniques, P-type transistors and N-type transistors are fabricated into the P-type silicon substrate 200. As shown, each transistor has a gate, source, and drain, which are fabricated into appropriate wells. The pattern of alternating P-type transistors and N-type transistors creates a complementary metal oxide semiconductor (CMOS) device.

A first oxide layer 202 is fabricated over the transistors and substrate 200. Conventional photolithography, etching, and deposition techniques are used to create tungsten plugs 210 and copper lines 212. The tungsten plugs 210 provide electrical connections between the copper lines 212 and the active features on the transistors. A second oxide layer 204 may be fabricated over the first oxide layer 202 and copper lines 212. Conventional photolithography, etching, and deposition techniques are used to create copper vias 220 and copper lines 214 in the second oxide layer 204. The copper vias 220 provide electrical connections between the copper lines 214 in the second layer and the copper lines 212 or the tungsten plugs 210 in the first layer.

The wafer then typically undergoes a copper CMP process to planarize the surface of the wafer, leaving a level surface as shown in Figure 2A. After the copper CMP process, the wafer is cleaned in the wafer cleaning system, as discussed above with reference to Figure 1.

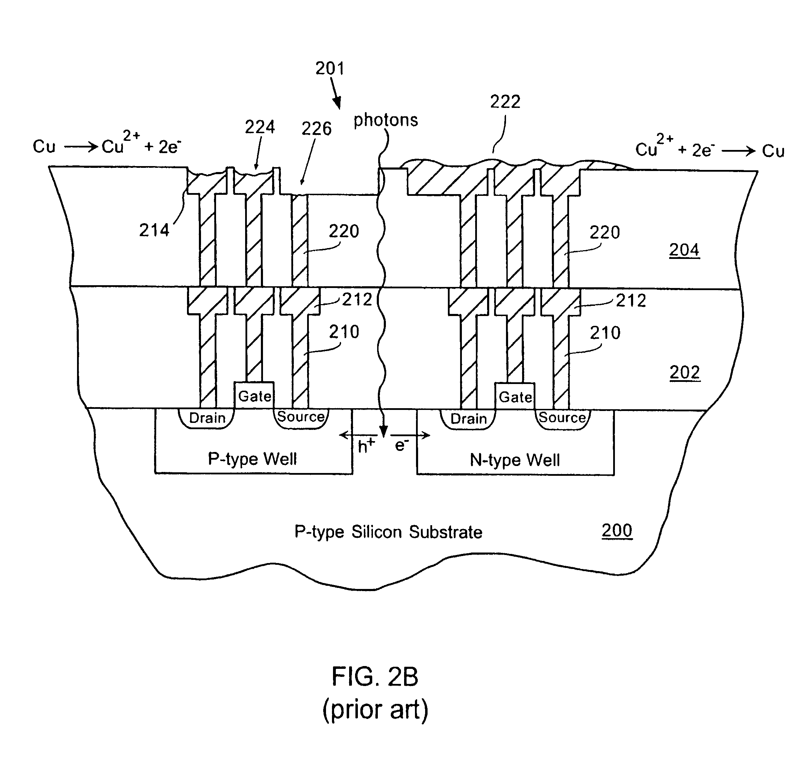

Figure 2B shows the partial cross-sectional view of the conventional semiconductor wafer of Figure 2A after the wafer has undergone a cleaning in the wafer cleaning system of Figure 1. As shown, the copper lines 214 on the top layer have been subjected to photo-corrosion during the cleaning process. The photo-corrosion is believed to be partially caused by light photons that pass through the clear plastic cover 102 of the brush box 100 and reaches the P/N junctions, which can act as solar cells. The light photons are projected on the clear plastic cover 102 by way of normal cleanroom lighting. Unfortunately, this amount of normal light, which is generally needed to view the cleaning process (i.e., view whether the brushes are properly cleaning the wafers), causes a catastrophic corrosion effect.

In this cross-sectional example, the copper lines, copper vias, or tungsten plugs are electrically connected to different parts of the P/N junction. The cleaning solution used to clean the wafer surface, which is typically an electrolite, closes the electrical circuit as electrons *e*^{*-*} and holes *h*^{*+*} are transferred across the P/N junctions. The electron/hole pairs photo-generated in the junction are separated by the electrical field. The introduced carriers induce a potential difference between the two sides of the junction. This potential difference increases with light intensity. Accordingly, at the electrode connected to the P-side of the junction, the copper is corroded: Cu → Cu²⁺ + 2*e*⁻. The produced soluble ionic species can diffuse to the other electrode, where the reduction can occur: Cu²⁺ + *2e*^{*-*} → Cu. Note that the general corrosion formula for any metal is *M → M*^{*n*+} + *ne*, and the general reduction formula for any metal is *M*^{*n*+} + *ne*^{*-*} *→ M.*

Unfortunately, this type of photo-corrosion displaces the copper lines and destroys the intended physical topography of the copper features, as shown in Figure 2B. At some locations on the wafer surface over the P-type transistors, the photo-corrosion effect may cause corroded copper lines 224 or completely dissolved copper lines 226. In other words, the photo-corrosion may completely corrode the copper line such that the line no longer exists. On the other hand, over the N-type transistors, the photo-corrosion effect may cause copper deposit 222 to be formed. This distorted topography, including the corrosion of the copper lines, will cause device defects that render the entire chip inoperable. One defective device means the entire chip must be discarded, thus, decreasing yield and drastically increasing the cost of the fabrication process. This effect, however, will generally occur over the entire wafer, thus destroying all of the chips on the wafer. This, of course, increases the cost of fabrication.

Various attempts have been made to reduce the corrosion phenomenon. One attempt involves adding corrosion inhibitors in chemical cleaning solutions used to clean wafer surfaces. Examples of corrosion inhibitors include complexing agents or passivating agents. This method of altering the chemical cleaning solution, however, has not proven to be adequately effective. For more information on photo-corrosion effects, reference can be made to an article by A. Beverina et al., "Photo-Corrosion Effects During Cu Interconnection Cleanings," published in the *196*^{*th*} *ECS Meeting,* Honolulu, Hawaii (October 1999).

In view of the foregoing, there is a need for a cleaning process that avoids the problems of the prior art by implementing improved techniques for reducing the photo-corrosion effect on wafers during cleaning.

### SUMMARY OF THE INVENTION

The present invention fills these needs by providing a method according to claim 1 and an apparatus according to claim 4 for substantially eliminating the photo-corrosion effect in semiconductor wafers during cleaning operations. It should be appreciated that the present invention can be implemented in numerous ways.

The present invention addresses the problem of photo-assisted corrosion by providing a cover in a wafer wet cleaning system that can be tuned from being substantially transparent to being opaque. When the cover is opaque, the cleaning process can be run in the substantial absence of light, thereby nearly eliminating the damaging effects of light energy on the wafer surface. In addition to stand-alone cleaning systems, the cover can also be integrated into a post-chemical mechanical polishing (post-CMP) cleaning system in order to minimize photo-assisted corrosion. Photo-assisted corrosion can also be minimized by integrating such a cover to an integrated CMP tool. Integrated CMP tools are those that implement both a cleaning module and a CMP module. Typically, these modules are joined or connected by way of special wafer handling equipment.

Thus, a wafer being cleaned will not be effected by photo-corrosion that displaces copper lines and that destroys the intended topography of the copper features. As a result, device defects that render the entire chip inoperable will be substantially reduced. Fewer chips will have to be discarded, yield will preferably increase, and the cost of running the fabrication process will not unduly increase.

Other aspects and advantages of the present invention will become apparent from the following detailed description, taken in conjunction with the accompanying drawings, illustrating by way of example the principles of the present invention.

### BRIEF DESCRIPTION OF THE DRAWINGS

The present invention will be readily understood by the following detailed description in conjunction with the accompanying drawings, in which like reference numerals designate like structural elements.
Figure 1 shows a wafer cleaning system having a brush box.
Figure 2A shows a cross-sectional view of a conventional semiconductor chip after the top layer has undergone a copper CMP process.
Figure 2B shows a cross-sectional view of the conventional semiconductor chip of Figure 2A after the wafer has undergone a cleaning in the wafer cleaning system of Figure 1.
Figure 3A shows a top view of a wafer cleaning system, in accordance with one embodiment of the present invention.
Figure 3B shows a side view of a wafer cleaning system, in accordance with one embodiment of the present invention.
Figure 3C shows a side view of a wafer cleaning system, in accordance with one embodiment of the present invention.
Figure 4A shows a side view of a composite material used for the cover on a wafer cleaning system.
Figure 4B shows a top view of a composite material used for the cover on a wafer cleaning system.
Figure 5 shows a high-level schematic diagram of preferred system components for the tunable transparency cover, in accordance with one embodiment of the present invention.
Figure 6A shows a flow chart of a method for forming a composite material.
Figure 6B shows a flow chart of a method for forming a transparency tunable cover for a wafer cleaning system.

### DETAILED DESCRIPTION OF THE PREFERRED EMBODIMENTS

An invention for methods and systems for reducing photo-assisted copper corrosion during a wafer cleaning process are disclosed. In the following description, numerous specific details are set forth in order to provide a thorough understanding of the present invention. It will be understood, however, to one skilled in the art, that the present invention may be practiced without some or all of these specific details. In other instances, well known process operations have not been described in detail in order not to unnecessarily obscure the present invention.

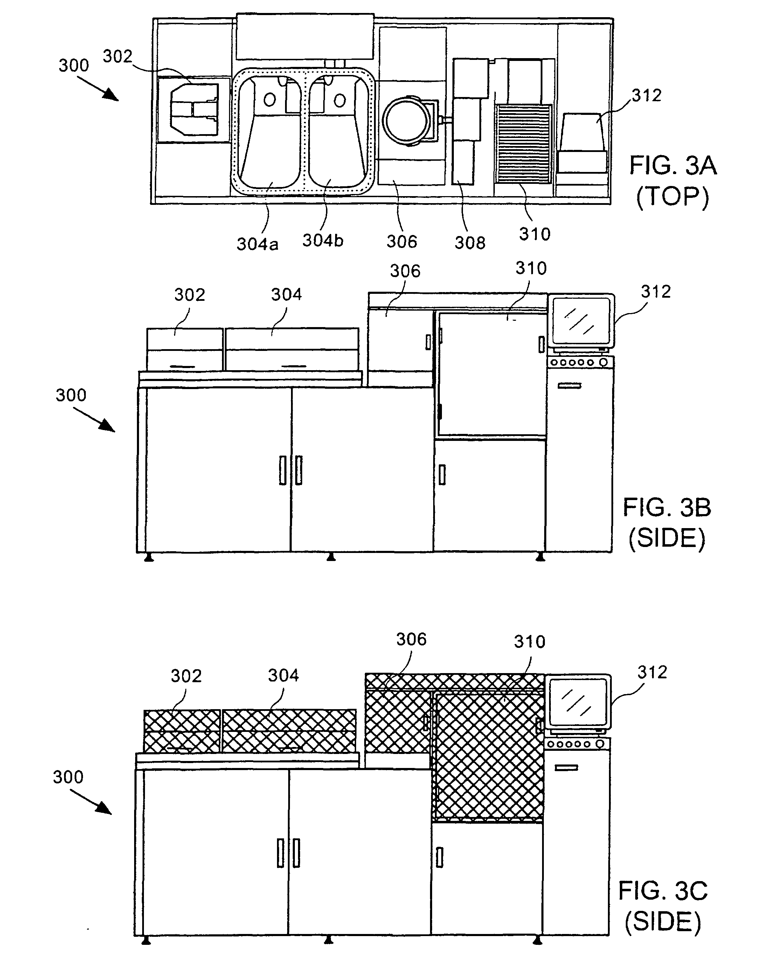

Figures 3A, 3B, and 3C show a top view and side views, respectively, of a wafer cleaning system, in accordance with one embodiment of the present invention. The wafer cleaning system 300 typically includes an input station 302 where a plurality of wafers may be inserted for cleaning through the system after the wafers have undergone CMP operations. Once the wafers are inserted into the input station 302, a wafer may be taken from the input station 302 and moved into the brush box 304, which contains a first brush box 304a and a second brush box 304b. Inside the brush box, various cleaning operations may be applied to the wafer.

After brushes have been applied to the wafer in the brush boxes 304, the wafer is moved into a spin, rinse, and dry (SRD) station 306. In the SRD station 306, de-ionized (DI) water is sprayed onto the surface of the wafer while the wafer is spun at a speed of between about 100 and 400 revolutions per minute, and then is spun to dry. After the wafer has been placed through the SRD station 306, an unload handler 308 takes the wafer and moves it into an output station 310. The cleaning system 300 is programmed and controlled from system electronics 312.

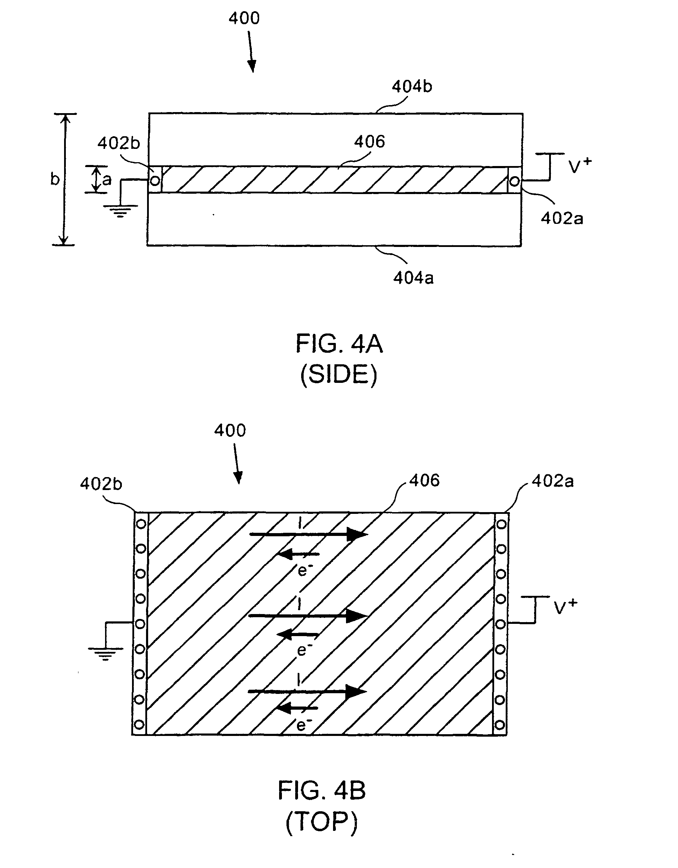

The transparency level of the cover of the wafer cleaning system 300 is tunable from being substantially transparent to being opaque, as shown in Figure 3C. The "cover" is the portion of the wafer cleaning system that houses the wafer cleaning operations. The term "substantially transparent" means substantially all of the light that is directed toward the outer surface of the cover passes through the cover. The term "opaque" means about none of the light that is directed toward the outer surface of the cover passes through the cover. The "outer surface of the cover" refers to the surface of the cover that is not facing the wafer cleaning operations. The term "light" refers to light that is within the ultra-violet (UV) and visible spectrum. Depending on the material used to construct the cover, a change in transparency may be accompanied by a corresponding change in color, as further discussed below with reference to figure 4A.

When the cover is substantially transparent, a user can view the cleaning process. However, as discussed in greater detail above, light energy may assist in corroding copper lines when cleaning is performed after a copper CMP process. Accordingly, the present invention provides a cover for the cleaning system that can be tuned to be opaque when cleaning operations are being performed and substantially transparent when the cleaning is not being performed. In certain cases, it may be desired to run a cleaning operation when the cover is substantially opaque, but the inner cleaning operations can still be viewed. This will allow an operator to determine whether the brushes are operating properly, and the like.

Figures 4A and 4B show a side view and a top view, respectively, of a composite material 400 used for the cover on a wafer cleaning system. The composite material 400 preferably includes a first transparent layer 404a, a second transparent layer 404b, and a transparent tunable layer 406 coated between the transparent layers 404. The transparency layers 404 are preferably a clear acrylic material. Although, other known plastics and/or glass can also be used.

The transparency tunable layer 406 is electrochromic material, such as tungsten oxide (WO₃, WOₓ). Alternative materials can include, for example, NB₂O₅, V₂O₇, TiO₂, ZnO, Cr₂O₃, MnO₂, CoO, NiO₂. Any one of these materials can also be implemented depending on the specific application. For purposes of this exemplary discussion, reference will be made to tungsten oxide. To create the composite material, the transparency tunable layer 406 is preferably sputtered onto the first transparency layer 404a (or the second transparency layer 404b). Another technique is a spin-on technique, where the transparency tunable layer 404a is, for example, formed by a "sol-gel" process. The second transparency layer 404b is formed atop the transparency tunable layer 406.

Sets of electrical connections 402a and 402b are conductively integrated to portions of the transparency tunable layer 406. When a bias voltage *V*⁺ is applied across the transparency tunable layer 406 between the portions, an electrical circuit defined by the electrical connections 402 and the transparency tunable layer 406 is closed. As shown in a preferred embodiment in Figure 4, a first portion is on a first side of the transparency tunable layer 406, and a second portion is on a second side of the transparency tunable layer 406.

As the desired voltage application *V*⁺ is increased, a current *I* that runs across the transparency tunable layer 406 proportionately increases. This increase in current causes electrons *e*⁻ to flow and excite the atoms in the electrochromic material. This excitation of atoms causes a change in transparency level, which may be accompanied by a change in color. Tungsten oxide, for example, is a light yellowish color in a lesser excited state, thereby making the tunable layer 406 substantially transparent. Tungsten oxide is a dark blue color in a more excited state, thereby making the tunable layer 406 opaque. In sum, a low voltage *V*⁺ causes the cover to be substantially transparent, while a high voltage *V*⁺ causes the cover to be opaque.

Generally, the voltage *V* ⁺ preferably ranges from between about 0.5 volts and about 3 volts, more preferably between about 1 volt and about 1.5 volts, and most preferably about 1.25 volts. Where tungsten oxide (WO₃) is used, the voltage *V*⁺ preferably ranges from between about 0.5 volts and about 5 volts, and most preferably about 3 volts.

The dimensions of the composite material 400 are preferably defined by at least two parameters, the cover thickness b and the tunable layer thickness a. The cover thickness b is preferably about 1 cm. The tunable layer thickness *a* is preferably between about 0.5 µm and about 10 µm, and most preferably about 3 µm.

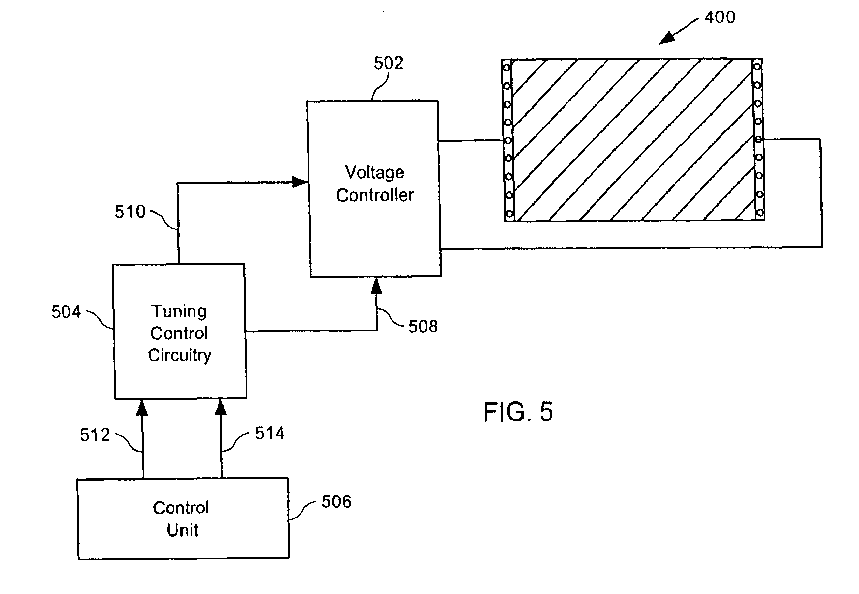

Figure 5 shows a high-level schematic diagram of preferred system components for the tunable transparency cover, in accordance with one embodiment of the present invention. A voltage controller 502 has electrodes (not shown) coupled to the electrical connections 402 and, thereby, establishes a bias voltage V across the transparency tunable layer 406. Tuning control circuitry 504 that receives input from a control unit 506 provides the appropriate state for the voltage controller 502. The control unit 506 provides a user with operation control 512 and emergency control 514. When the user is using the operation control 512, the tuning control circuitry 504 provides a state of regular operation 510 to the voltage controller 502. Operation control 512 allows the user to tune the voltage low or high, depending on the transparency level that is required.

When the user is using the emergency control 514, the tuning control circuitry 504 preferably provides a voltage shut-off to the voltage controller 502. When the voltage is shut-off, the composite material 400 is preferably in about its most transparent state. The emergency control 514 may be desired for cases when the cleaning system experiences a problem, e.g., a broken wafer, and the user needs to ascertain the problem immediately. In other cases, the emergency control 514 will be advantageous when the power unexpectedly shuts off and the operator needs to view the inside of the cleaner to determine the current state of a cleaning session.

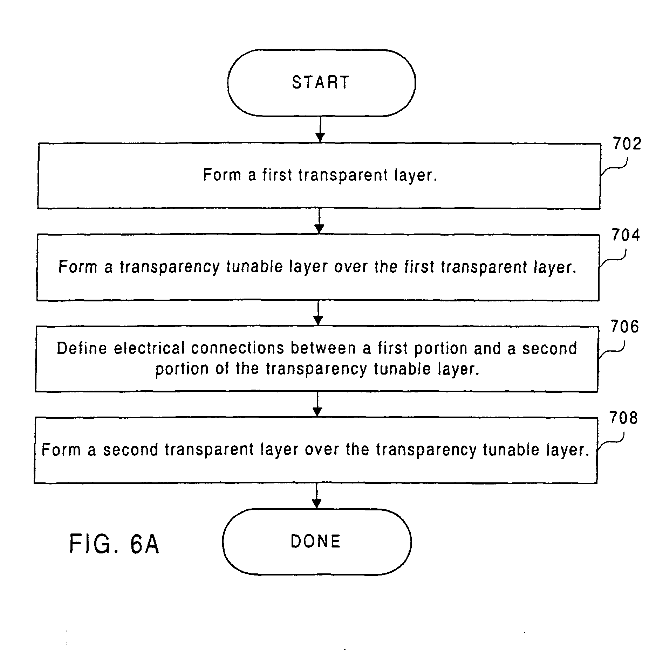

Figure 6A shows a flow chart of a method for forming a composite material 400. The method starts in operation 702 where a first transparent layer is formed. The method then proceeds to operation 704 where a transparency tunable layer is formed over the first transparent layer. The transparency tunable layer has characteristics such as those discussed with reference to Figures 4A and 4B. Next, the method moves to operation 706 where electrical connections are defined between a first portion and a second portion of the transparency tunable layer. The method then moves to operation 708 where a second transparent layer is formed over the transparency tunable layer.

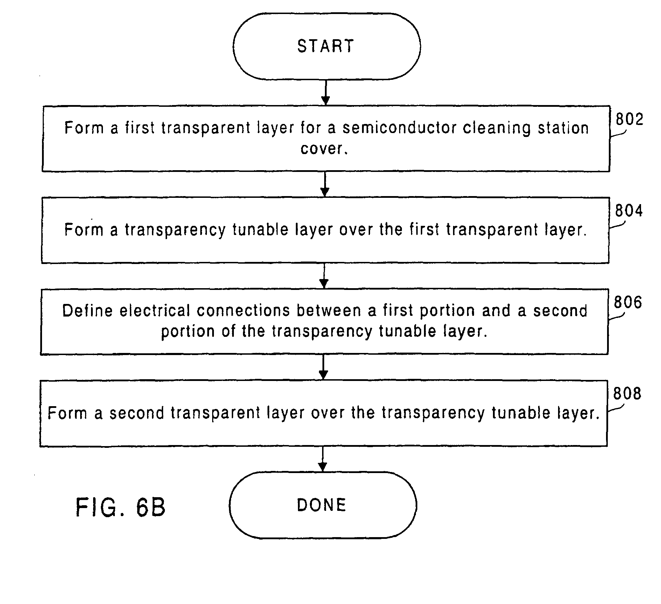

Figure 6B shows a flow chart of a method for forming a transparency tunable cover for a wafer cleaning system. The method starts in operation 802 where a first transparent layer is formed for a semiconductor cleaning station cover. The method then proceeds to operation 804 where a transparency tunable layer is formed over the first transparent layer.

The cover preferably has electrodes at appropriate ends to enable circuitry to couple thereto and enable a current flow, as discussed with reference to Figure 4B. The current flow through the cover will therefore enable the cover to change in transparency. When the cleaning system in operational, and the cleaning is being performed after a copper CMP, the photo-assisted corrosion will be advantageously prevented. This is a substantial advance in cleaning technology, in that conventional cleaning systems all use one-state clear covers that allow light to freely pass therethrough. A cleaning system using this tunable cover can now program the state of transparency to be substantially dark when the cleaning is in progress and light when no cleaning operation is being performed. Of course, the level of transparency can vary anywhere in between each extreme, depending on the users needs and the type of cleaning being performed.

Next, the method moves to operation 806 where electrical connections are defined between a first portion and a second portion of the transparency tunable layer. The method then moves to operation 808 where a second transparent layer is formed over the transparency tunable layer.

While this invention has been described in terms of several preferred embodiments, it will be appreciated that those skilled in the art upon reading the preceding specifications and studying the drawings will realize various alterations, additions, permutations and equivalents thereof. For example, although specific reference is made to brush boxes, any other brush scrubbing apparatus can benefit from the method teachings of the present invention. Additionally, the cleaning embodiments can be applied to any size wafer, such as, 200 mm, 300 mm, and larger, as well as other sizes and shapes. It is therefore intended that the present invention includes all such alterations, additions, permutations, and equivalents that fall within the scope of the invention as defined in the appended claims.

## Claims

1. A method of making a cover defined in a semiconductor substrate wet cleaning system, the method comprising:
forming a first transparent layer (404a);
forming a transparency tunable layer (406) over the first transparent layer (404a), said transparency tunable layer (406) being formed from an electrochromic material;
defining electrical connections between a first portion and a second portion of the transparency tunable layer (406); and
forming a second transparent layer (404b) over the transparency tunable layer.

2. A method as recited in claim 1, wherein the transparency tunable layer (406) is tungsten oxide.

3. A method as recited in claim 1, further comprising:
forming the first (404a) and the second transparent layers (404b) from acrylic.

4. A semiconductor wafer wet cleaning apparatus, said apparatus including a cover, the cover being a multi-layer composite material that includes,
a first transparent layer (404a);
a transparency tunable layer (406) over the first transparent layer (404a), said transparency tunable layer (406) being formed from an electrochromic material;
a first set of electrical connections attached to or integrated with the transparency tunable layer (406) at a first portion;
a second set of electrical connections attached to or integrated with transparency tunable layer (406) at a second portion; and
a second transparent layer (404b) over the transparency tunable layer (406);
the apparatus further comprising
a voltage controller (502) having a first electrode connector and a second electrode connector;
wherein the first electrode connector is coupled to the first set of electrical connections and the second electrode connector is coupled to the second set of electrical connections;
the apparatus further comprising tuning control circuitry (504) that integrates with the voltage controller (502), the tuning control circuitry (504) being configured to apply a bias voltage to the transparency tunable layer (406) to cause a change in a transparency level in the cover.

5. An apparatus as recited in claim 4, wherein an increase in the magnitude of the bias voltage decreases the transparency level in the cover; and
a decrease in the magnitude of the bias voltage increases the transparency level in the cover.

6. An apparatus as recited in claim 4, wherein when the magnitude of the bias voltage is about zero, the cover is substantially transparent.

7. An apparatus as recited in claim 4, the tuning control circuitry (504) being configured to apply a desired voltage to the transparency tunable layer (406) to cause a change in color in the cover;
wherein the change in color is configured to either limit or increase an amount of light that may pass through the cover.

8. An apparatus as recited in claim 4, wherein the apparatus is a brush box cleaning station.

9. An apparatus as recited in claim 4, wherein the apparatus is a post-chemical mechanical polishing (post-CMP) semiconductor wafer wet cleaning system.

10. An apparatus as recited in claim 4, wherein the apparatus is an integrated CMP tool having a cleaning module and a CMP module.

11. An apparatus as recited in claim 4, wherein the transparency tunable layer (406) is made from a material selected from the group consisting of WO₃, WOₓ, NB₂O₅, V₂O₇, TiO₂, ZnO, Cr₂O₃, MnO₂, CoO, and NiO₂.

## Patentansprüche

1. Verfahren zum Herstellen einer Abdeckung, die in einem Nassreinigungssystem für Halbleitersubstrate ausgebildet ist, wobei das Verfahren umfasst:
Ausbilden einer ersten transparenten Schicht (404a),
Ausbilden einer Schicht (406) mit einstellbarer Lichtdurchlässigkeit auf der ersten transparenten Schicht (404a), wobei die Schicht (406) mit einstellbarer Lichtdurchlässigkeit aus einem elektrochromen Material hergestellt wird;
Ausbilden von elektrischen Verbindungen zwischen einem ersten Bereich und einem zweiten Bereich der Schicht (406) mit einstellbarer Lichtdurchlässigkeit und
Ausbilden einer zweiten transparenten Schicht (404b) auf der Schicht mit einstellbarer Lichtdurchlässigkeit.

2. Verfahren nach Anspruch 1, bei dem die Schicht (406) mit einstellbarer Lichtdurchlässigkeit Wolframoxid ist.

3. Verfahren nach Anspruch 1, weiterhin umfassend:
Ausbilden der ersten (404a) und der zweiten (404b) transparenten Schicht aus Acryl.

4. Nassreinigungsvorrichtung für Halbleiterwafer, wobei die Vorrichtung eine Abdeckung aufweist und wobei die Abdeckung ein mehrschichtiges Verbundmaterial ist, mit
einer ersten transparenten Schicht (404a);
einer Schicht (406) mit einstellbarer Lichtdurchlässigkeit auf der ersten transparenten Schicht (404a), wobei die Schicht (406) mit einstellbarer Lichtdurchlässigkeit aus einem elektrochromen Material hergestellt ist;
einem ersten Satz elektrischer Verbindungen, die in einem ersten Bereich mit der Schicht (406) mit einstellbarer Lichtdurchlässigkeit verbunden oder einstückig mit dieser ausgebildet sind;
einem zweiten Satz elektrischer Verbindungen, die in einem zweiten Bereich mit der Schicht (406) mit einstellbarer Lichtdurchlässigkeit verbunden oder einstückig mit dieser ausgebildet sind, und
einer zweiten transparenten Schicht (404b) auf der Schicht (406) mit einstellbarer Lichtdurchlässigkeit,
wobei die Vorrichtung weiterhin umfasst:
einen Spannungsregler (502) mit einem ersten Elektrodenanschluss und einem zweiten Elektrodenanschluss;
wobei der erste Elektrodenanschluss mit dem ersten Satz elektrischer Verbindungen verbunden ist und der zweite Elektrodenanschluss mit dem zweiten Satz elektrischer Verbindungen verbunden ist;
wobei die Vorrichtung weiterhin eine Schaltung (504) zur Einstellungssteuerung aufweist, die in den Spannungsregler (502) integriert ist, wobei die Schaltung (504) zur Einstellungssteuerung so ausgebildet ist, dass sie eine Vorspannung an die Schicht (406) mit einstellbarer Lichtdurchlässigkeit anlegt, um eine Änderung im Lichtdurchlässigkeitsgrad der Abdeckung zu bewirken.

5. Vorrichtung nach Anspruch 4, wobei eine Erhöhung der Größe der Vorspannung den Lichtdurchlässigkeitsgrad der Abdeckung vermindert und eine Verminderung der Größe der Vorspannung den Lichtdurchlässigkeitsgrad der Abdeckung erhöht.

6. Vorrichtung nach Anspruch 4, wobei die Abdeckung im wesentlichen transparent ist, wenn die Größe der Vorspannung ungefähr Null beträgt.

7. Vorrichtung nach Anspruch 4, wobei die Schaltung (504) zur Einstellungssteuerung so ausgebildet ist, dass sie eine gewünschte Spannung an die Schicht (406) mit einstellbarer Lichtdurchlässigkeit anlegt, um eine Änderung in der Farbe der Abdeckung zu bewirken,
wobei die Änderung in der Farbe so gestaltet ist, dass die Menge des Lichtes, das durch die Abdeckung hindurch treten kann, entweder eingeschränkt oder erhöht wird.

8. Vorrichtung nach Anspruch 4, wobei die Vorrichtung eine Reinigungsstation mit Bürstenkasten ist.

9. Vorrichtung nach Anspruch 4, wobei die Vorrichtung ein Nassreinigungssystem für das Nachbehandeln beim chemisch-mechanischen Polieren (Post-CMP) von Halbleiterwafern ist.

10. Vorrichtung nach Anspruch 4, wobei die Vorrichtung ein integriertes CMP-Werkzeug mit einem Reinigungsmodul und einem CMP-Modul ist.

11. Vorrichtung nach Anspruch 4, wobei die Schicht (406) mit einstellbarer Lichtdurchlässigkeit aus einem Material gefertigt ist, das aus der Gruppe, bestehend aus WO₃, WOₓ, Nb₂O₅, V₂O₇, TiO₂, ZnO, Cr₂O₃, MnO₂, CoO und NiO₂, ausgewählt ist.

## Revendications

1. Procédé de fabrication d'un couvercle définit dans un système de nettoyage humide d'un substrat semi-conducteur, le procédé comprenant les étapes consistant à :
former une première couche transparente (404a) ;
former une couche (406) à transparence réglable sur la première couche transparente (404a), ladite couche (406) à transparence réglable étant formée à partir d'un matériau électrochromique ;
définir des connexions électriques entre une première partie et une deuxième partie de la couche (406) à transparence réglable ; et
former une seconde couche transparente (404b) sur la couche à transparence réglable.

2. Procédé selon la revendication 1, dans lequel la couche (406) à transparence réglable est de l'oxyde de tungstène.

3. Procédé selon la revendication 1, comprenant en outre :
la formation de la première (404a) et la seconde couches (404b) transparentes à partir d'acrylique.

4. Appareil de nettoyage humide d'une tranche de semi-conducteur, ledit appareil comprenant un couvercle, le couvercle étant un matériau composite multicouche qui comprend,
une première couche transparente (404a) ;
une couche (406) à transparence réglable au-dessus de la première couche transparente (404a), ladite couche (406) à transparence réglable étant formée à partir d'un matériau électrochromique ;
un premier ensemble de connexions électriques fixées à ou intégrées à la couche (406) à transparence réglable au niveau d'une première partie ;
un second ensemble de connexions électriques fixées à ou intégrées à la couche (406) à transparence réglable au niveau d'une seconde partie ; et
une seconde couche transparente (404b) au-dessus de la couche (406) à transparence réglable ;
l'appareil comprenant en outre :
un contrôleur (502) de tension possédant un premier connecteur d'électrode et un second connecteur d'électrode ;
où le premier connecteur d'électrode est couplé au premier ensemble de connexions électriques et le second connecteur d'électrode est couplé au second ensemble de connexions électriques ;
l'appareil comprenant en outre un ensemble de circuits (504) de commande d'accord qui s'intègre avec le contrôleur (502) de tension, l'ensemble de circuits (504) de commande d'accord étant configuré pour appliquer une tension de polarisation à la couche (406) à transparence réglable afin de provoquer un changement dans le niveau de transparence du couvercle.

5. Appareil selon la revendication 4, dans lequel une augmentation de l'amplitude de la tension de polarisation entraîne la diminution du niveau de transparence du couvercle ; et
une diminution de l'amplitude de la tension de polarisation entraîne une augmentation du niveau de transparence du couvercle.

6. Appareil selon la revendication 4, dans lequel lorsque l'amplitude de la tension de polarisation est d'environ zéro, le couvercle est sensiblement transparent.

7. Appareil selon la revendication 4, l'ensemble de circuits (504) de commande d'accord étant configuré pour appliquer une tension désirée à la couche (406) à transparence réglable afin de provoquer un changement de couleur du couvercle ;
où le changement de couleur est configuré soit pour limiter soit pour augmenter une quantité de lumière qui peut passer à travers le couvercle.

8. Appareil selon la revendication 4, où l'appareil est une station de nettoyage de la cage de porte-balais.

9. Appareil selon la revendication 4, où l'appareil est un système de nettoyage humide d'une tranche de semi-conducteur post-polissage mécanique chimique (post-CMP).

10. Appareil selon la revendication 4, où l'appareil est un outil de polissage mécanique et chimique intégré ayant un module de nettoyage et un module de polissage mécanique et chimique.

11. Appareil tel qu'exposé selon la revendication 4, où la couche 406 à transparence réglable est fabriquée dans un matériau choisi dans le groupe comportant du WO₃, WOₓ, NB₂O₅, V₂O₇, TiO₂, ZnO, Cr₂O₃, MnO₂, CoO et NiO₂.
